Europäisches Patentamt

(19) European Patent Office

Office européen des brevets

(11) Veröffentlichungsnummer: **0 050 244**
**B1**

(12) # EUROPÄISCHE PATENTSCHRIFT

(45) Veröffentlichungstag der Patentschrift:
**02.01.85**

(51) Int. Cl.³: **H 01 R 9/24,** H 05 K 5/03,
H 02 B 1/06

(21) Anmeldenummer: **81107796.5**

(22) Anmeldetag: **01.10.81**

(54) **Lösbare Abdeckung für Klemmleisten.**

(30) Priorität: **18.10.80 DE 3039478**

(43) Veröffentlichungstag der Anmeldung:
**28.04.82 Patentblatt 82/17**

(45) Bekanntmachung des Hinweises auf die Patenterteilung:
**02.01.85 Patentblatt 85/1**

(84) Benannte Vertragsstaaten:
**AT CH DE FR GB LI NL SE**

(56) Entgegenhaltungen:
**DE - A - 2 304 573**
**DE - U - 7 811 186**
**FR - A - 1 324 684**
**FR - A - 2 239 777**
**US - A - 3 602 875**
**US - A - 3 964 705**
**US - A - 4 130 332**

(73) Patentinhaber: **A. Grothe & Söhne KG, Höninger Weg 153, D-5000 Köln-Zollstock (DE)**

(72) Erfinder: **Sella, Hans-Adolf, Pflasterhofweg 53, D-5000 Köln 50 (Weiss) (DE)**

(74) Vertreter: **Grosse, Dietrich, Dipl.-Ing. et al, Patentanwälte F.W. Hemmerich, Gerd Müller, Dipl.-Ing. D. Grosse, Felix Pollmeier Hammerstrasse 2, D-5900 Siegen 1 (DE)**

## Beschreibung

Die Erfindung betrifft eine lösbare Abdeckung für Klemmleisten von Elektrogeräten gemäß Oberbegriff des Anspruches 1.

Nach den geltenden Sicherheitsvorschriften sollen Abdeckkappen für Klemmleisten von Elektrogeräten, insbesondere von Transformatoren, zuverlässig und unverrückbar auf dem Gehäuse bzw. dem Gerätesockel befestigt sein; diese Befestigung soll durch mindestens zwei voneinander unabhängige Mittel erfolgen, die gegen unbefugtes Entfernen der Abdeckkappe gesichert sind, indem das Lösen mindestens eines der Befestigungsmittel nur durch ein Werkzeug erfolgen kann.

Bei einer bekannten Klemmenabdeckung der eingangs genannten Gattung erfolgt die Arretierung der Abdeckkappen mittels zweier Schrauben. Es wurde auch bereits vorgeschlagen, eine Abdeckkappe mit nur einer Schraube zu befestigen und zusätzlich am Gehäuse und der Abdeckkappe Kerben und Vorsprünge vorzusehen. Solche Schrauben lassen sich zwar nur mittels eines Werkzeuges, des Schraubendrehers, entfernen, sie erweisen sich aber bei der Montage, beim Anschließen und bei der Demontage als unvorteilhaft, da sowohl das Ein- als auch das Ausdrehen schon einer Schraube sich als unliebsam zeitaufwendig erweist. Zudem ist bei der Verwendung von Schrauben in Verbindung mit Isoliergehäusen von Elektrogeräten ebenfalls aus Sicherheitsgründen der Einsatz von metallenen Muttern vorgeschrieben, die entweder vor dem Spritzen des Isoliergehäuses in die Spritzgußform einzulegen sind oder aber in einem zusätzlichen Arbeitsgang mit dem fertiggestellten Isoliergehäuse zu verbinden sind.

Aus der DE-U-7 811 186 sind Abdeckkappen bekannt, die Gehäuseteile umgreifen und sich auf diesen formschlüssig mittels in Öffnungen eingreifender Vorsprünge halten. Zum Lösen der Verbindung werden beide Gehäuseteile umgreifende Flanken mittels eines Werkzeuges vom Gehäuse und dessen Verschlußelementen freigehoben. Bei diesem Aufweiten werden jedoch Teile der Abdeckkappe und gegebenenfalls auch des Gehäuses unliebsam verformt, und die gleichzeitige Benutzung zweier Werkzeuge erweist sich auch beim Vorliegen entsprechender Geschicklichkeit und bei ständiger Übung als schwierig und zeitraubend, und das Gleiche gilt auch für das dort empfohlene zunächst einseitige Lösen, anschließende Verkanten der Abdeckkappe und Ansetzen des Werkzeuges auf der gegenüberliegenden Flanke. Als schwierig erweist es sich weiterhin insbesondere bei gedrängtem Aufbau, daß der Ansatz der Werkzeuge seitlich zu erfolgen hat.

Zwei einander gegenüberliegende Rastverschlüsse werden auch für das Halten der Frontplatten unter Putz zu installierender Schalter nach der DE-PS 1 160 524 empfohlen. Auch hier wird die Notwendigkeit des Lösens zweier Verschlüsse mittels jeweils eines Werkzeuges als unangenehm empfunden; eine Abhilfe sollen jeweils im Bereich einer der Rastvorrichtungen vorgesehene, die Abdeckkappe vorspannende Federn bringen, die nach Lösen einer der Rastvorrichtungen in deren Bereich die Abdeckkappe schon so weit abheben, daß ein Wiedereinrasten vermieden wird, so daß nunmehr die andere Rast lösbar ist. Auch hier wird zum Entfernen der Frontplatte noch eine unerwünschte hohe Übung bzw. Geschicklichkeit erforderlich, und nachteilig macht sich bemerkbar, daß die von den Rastfedern gehaltene Frontplatte unter Einwirkung sie beaufschlagender Kräfte noch unerwünscht große Verschiebungen erfährt, welche den sicheren Halt über den abzudeckenden Schaltelementen beeinträchtigen.

Die Erfindung geht daher von der Aufgabe aus, eine lösbare Abdeckung der eingangs genannten Gattung zu schaffen, das durch fremdkraftresistenten, exakten Sitz und Halt den bestehenden Sicherheitsvorschriften genügt, das sich einfach und billig herstellen läßt, und das es erlaubt, schnell und mit geringem Aufwande unter nur einmaligem Einsatz eines Werkzeuges die Abdeckkappen vom eigentlichen Gehäuse zu lösen als auch mit diesem wieder zu verbinden.

Gelöst wird diese Aufgabe gemäß den kennzeichnenden Merkmalen des Anspruches 1, was ein schnelles Anbringen bzw. Abnehmen des Abdeckgehäuses durch das Ein- bzw. Entrasten des Schnappverschlusses ermöglicht.

Bewährt hat sich insbesondere eine Anordnung, bei der der Schnappverschluß aus einer Nase innerhalb des Abdeckgehäuses und einer einstückig am Gerätesockel angeformten, mit einem hinter der Nase einrastbaren Haken versehenen federnden Zunge besteht, und bei der am Gerätesockel und/oder an dessen Isolierstegen parallel zur Zungenlängsachse verlaufende Führungen sowie am Abdeckgehäuse mit diesen zusammenwirkende Führungselemente der Abdeckkappe vorgesehen sind, und bei der die Abdeckkappe oberhalb der Nase eine Öffnung zum Lösen des Schnappverschlusses aufweist.

Als vorteilhaft hat es sich erwiesen, die Öffnung als Schlitz auszubilden, dessen Länge der Breite des Hakens entspricht, und die Öffnung so anzuordnen, daß sie bei eingerastetem Haken die vom Haken und der Zunge gebotenen Stirnflächen übergreift. Die Betätigung des Schnappverschlusses durch ein Werkzeug, insbesondere einen Schraubendreher, wird vereinfacht, wenn die Stirnfläche des Hakens zu dessen freiem Ende hin rampenartig abfällt. Zweckmäßig ist hierbei die Zunge so angeordnet, daß sie in ihrer Raststellung mit der Stirnfläche ihres Hakens die Öffnung des Abdeckgehäuses schließt. Bei am Gehäusesockel vorgesehenen parallelen, zur Aufnahme von Anschlußklemmen vorgesehene Taschen bildenden Isolierstegen hat es sich bewährt, die Zunge zwischen zwei Isolierstegen in einer anschlußklemmenfreien Tasche anzuordnen.

Ein Ausführungsbeispiel der Erfindung wird anhand der Zeichnungen näher erläutert. Es zeigt

Fig. 1 die Vorderansicht der Abdeckgehäuseinnenseite,

Fig. 2 einen Teil der Draufsicht des Gerätesokkels und

Fig. 3 die Seitenansicht des Abdeckgehäuses und des Gerätesockels im Schnitt.

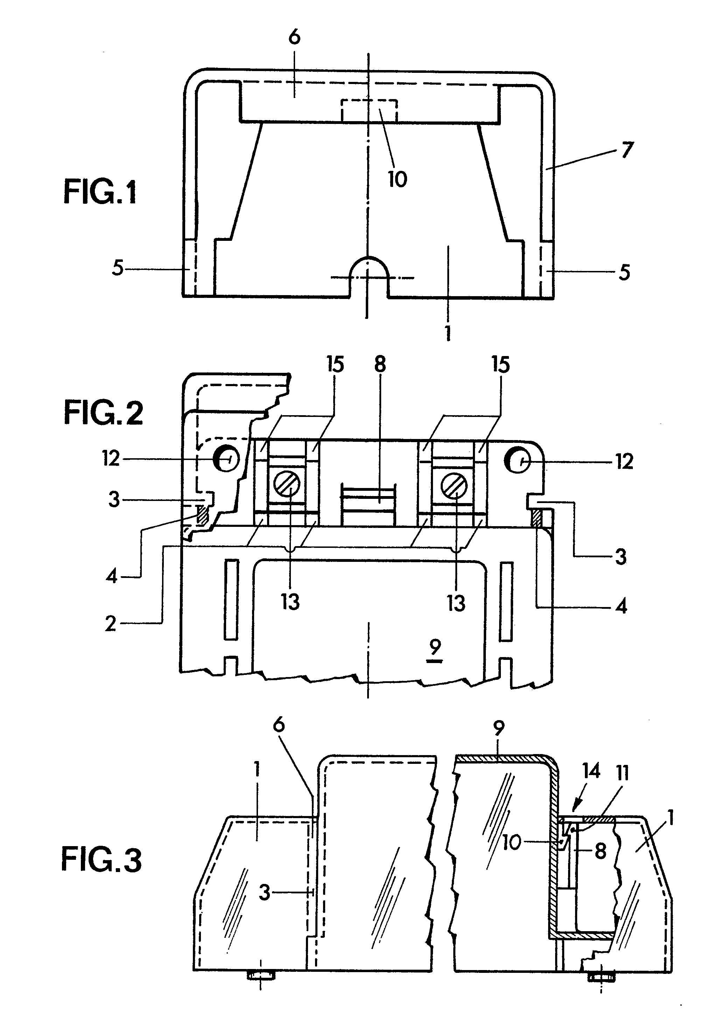

Fig. 1 zeigt die Innenseite des Abdeckgehäuses 1 mit seinen Führungselementen 5, 6 und 7, die mit den Führungen 2, 3 und 4 des Gerätesokkels 9 laut Fig. 2 zusammenwirken. Mit der Führung 6 ist die Nase 10 einstückig und mittig derart verbunden, daß sie in den Haken 11 der Zunge 8 einschnappen kann (Fig. 3).

Der Gerätesockel 9 in Fig. 2 weist die Isolierstege 15 auf, zwischen denen die Zunge 8 mit ihrem Haken 11 mittig und die Klemmen 13 außermittig angeordnet sind. Die Führungen 2, 3 und 4 wirken mit den Führungselementen 5, 6 und 7 zusammen (Fig. 1), und die Bohrungen 12 dienen zur Befestigung des Gerätesockels 9 auf dem für den Transformator vorgesehenen Platz.

Fig. 3 stellt den Gerätesockel 9 mit dem primär- und sekundärseitigen Abdeckgehäuse 1 eines Transformators dar. Am Gehäusesockel 9 ist die Zunge 8 mit einem Haken 11 einstückig angeformt. Die Nase 10 des Abdeckgehäuses 1 ist hinter den Haken 11 der Zunge 8 eingehakt. Dadurch wird die Öffnung 14 des Abdeckgehäuses 1 von dem Haken 11 der Zunge 8 verschlossen. Weiterhin wirkt das Führungselement 6 des Abdeckgehäuses 1 mit der Führung 3 des Gerätesockels 9 zusammen.

**Patentansprüche**

1. Lösbare Abdeckung für Klemmleisten von Elektrogeräten, insbesondere von Transformatoren, mit einem Abdeckgehäuse (1), dessen Arretierung auf dem aus Kunststoff gefertigten Gerätesockel (9) durch mindestens zwei voneinander unabhängige Befestigungsmittel erfolgt, wobei zum Lösen mindestens eines dieser Mittel die Benutzung eines Werkzeuges erforderlich ist, dadurch gekennzeichnet, daß ein Befestigungsmittel als gegen den Gerätesockel (9) oder dessen Grundfläche gerichtete Führung (2 bis 7) ausgebildet ist und daß als zweites Befestigungsmittel nur ein mittels eines Werkzeuges lösbarer, die Abdeckkappe (1) in der Endstellung ihrer Führung arretierender Schnappverschluß (8, 10, 11) vorgesehen ist.

2. Lösbare Abdeckung nach Anspruch 1, dadurch gekennzeichnet, daß der Schnappverschluß aus einer Nase (10) innerhalb des Abdeckgehäuses (1) und einer einstückig am Gerätesockel (9) angeformten, mit einem hinter der Nase einrastbaren Haken (11) versehenen federnden Zunge (8) besteht, daß am Gerätesockel (9) und/oder an dessen Isolierstegen (5) parallel zur Zungenlängsachse verlaufende Führungen (2, 3, 4) sowie am Abdeckgehäuse (1) mit diesen zusammenwirkende Führungselemente (5, 6, 7) vorgesehen sind und daß die Abdeckkappe (1) oberhalb der Nase (10) eine Öffnung (14) zum Lösen des Schnappverschlusses aufweist.

3. Lösbare Abdeckung nach Anspruch 2, dadurch gekennzeichnet, daß die Öffnung (14) als Schlitz ausgebildet ist, dessen Länge der Breite des Hakens (11) entspricht, und daß bei eingerastetem Haken (11) die Öffnung (14) die vom Haken (11) und der Zunge (8) gebotenen Stirnflächen übergreift.

4. Lösbare Abdeckung nach Anspruch 2 oder 3, dadurch gekennzeichnet, daß die Stirnfläche des Hakens (11) zu dessen freiem Ende hin rampenartig abfällt.

5. Lösbare Abdeckung nach einem der Ansprüche 2 bis 4, dadurch gekennzeichnet, daß die Zunge (8) in ihrer Raststellung mit der Stirnfläche ihres Hakens (11) die Öffnung (14) des Abdeckgehäuses (1) schließt.

6. Lösbare Abdeckung nach einem der Ansprüche 1 bis 5 mit am Gerätesockel (9) vorgesehenen parallelen, zur Aufnahme von Anschlußklemmen (13) vorgesehenen Taschen bildenden Isolierstegen (15), dadurch gekennzeichnet, daß die Zunge (8) zwischen zwei Isolierstegen (15) in einer anschlußklemmenfreien Tasche angeordnet ist.

**Claims**

1. A removable covering for terminal blocks of electrical apparatus, in particular transformers, having a cover casing (1) the locking of which onto the base (9), manufactured from plastics, of the apparatus is effected by at least two means of fastening independent of one another, the use of a tool being necessary for the release of at least one of these means, characterized in that one means of fastening is made as a guide (2 to 7) directed towards the base (9) of the apparatus or ist back face, and that as the second means of fastening only one spring catch (8, 10, 11) is provided, which locks the cover cap (1) into the end position of ist guide and can be released by means of a tool.

2. A removable covering as in Claim 1, characterized in that the spring catch consists of a nose (10) inside the cover casing (1) and a springy tongue (8) moulded in one piece with the base (9) of the apparatus and provided with a hook (11) able to catch behind the nose, that on the base (9) of the apparatus and/or on its insulating webs (15) guides (2, 3, 4) are provided running in parallel with the longitudinal axis of the tongue, as well as guide members (5, 6, 7) on the cover casing (1) cooperating with them, and that the cover cap (1) exhibits above the nose (10) an opening (14) for the release of the spring catch.

3. A removable covering as in Claim 2, characterized in that the opening (14) is made as a slot the length of which corresponds with the width of the hook (11) and that with the hook (11) snapped home the opening (14) overlaps the endfaces presented by the hook (11) and the tongue (8).

4. A removable covering as in Claim 2 or 3, characterized in that the endface of the hook (11) slopes like a ramp towards its free end.

5. A removable covering as in one of the Claims 2 to 4, characterized in that the tongue (8) in its snapped-home position closes by the endface of its hook (11) the opening (14) in the cover casing (1).

6. A removable covering as in one of the Claims 1 to 5, with parallel insulating webs (15) provided on the base (9) of the apparatus to form pockets intended for receiving terminal blocks (13), characterized in that the tongue (8) is arranged between two insulating webs (15) in a pocket free of terminal blocks.


## Revendications

1. Couverture amovible pour barres à bornes d'appareils électriques, notamment de transformateurs, avec un capot (1) dont le blocage sur le socle en matière synthétique (9) de l'appareil est effectué par au moins deux moyens de fixation indépendants l'un de l'autre, l'utilisation d'un outil étant nécessaire pour défaire au moins l'un de ces moyens de fixation, caractérisée en ce qu'un moyen de fixation est conçu sous forme de guidage (2 à 7) dirigé vers le socle de l'appareil ou la surface de base de celui-ci, et en ce que comme deuxième moyen de fixation est prévue seulement une fermeture à encliquetage (8, 10, 11) qui bloque le capot (1) dans la position finale de son guidage et qui peut être défaite seulement au moyen d'un outil.

2. Couverture amovible selon la revendication 1, caractérisée en ce que la fermeture à encliquetage se compose d'un ergot (10) à l'intérieur du capot (1) d'une languette flexible (8) venue de moulage d'une seule pièce sur le socle (9) de l'appareil et munie d'un crochet (11) pouvant s'encliqueter derrière l'ergot, en ce que sont prévus, sur le socle (9) de l'appareil et/ou sur les nervures d'isolation (5) de celui-ci, des guidages (2, 3, 4) orientés parallèlement à l'axe longitudinal de la languette, ainsi que, sur le capot (1), des éléments de guidage (5, 6, 7) coopérant avec ces guidages, et en ce que le capot (1) présente au-dessus de l'ergot (10) une ouverture (14) pour défaire la fermeture à encliquetage.

3. Couverture amovible selon la revendication 2, caractérisée en ce que l'ouverture (14) est en forme de fente dont la longueur correspond à la largeur du crochet (11), et en ce que lorsque le crochet (11) est encliqueté l'ouverture (14) recouvre les surfaces d'extrémité offertes par le crochet (11) et la languette (8).

4. Couverture amovible selon la revendication 2 ou 3, caractérisée en ce que la surface d'extrémité du crochet (11) descend à la manière d'une rampe en direction de l'extrémité libre de ce crochet.

5. Couverture amovible selon une des revendications 2 à 4, caractérisée en ce que la surface d'extrémité du crochet (11) de la languette (8) ferme l'ouverture (14) du capot (1) lorsque cette languette est en position encliquetée.

6. Couverture amovible selon une des revendications 1 à 5, avec des nervures d'isolation (15) parallèles sur le socle (9) de l'appareil prévues pour recevoir des bornes de raccordement (13) et formant des poches, caractérisée en ce que la languette (8) est disposée entre deux nervures d'isolation (15) dans une poche dépourvue de borne de raccordement.

**FIG.1**

**FIG.2**

**FIG.3**